**Europäisches Patentamt**

**European Patent Office**

**Office européen des brevets**

(19)

(11) Veröffentlichungsnummer: **0 029 163**
**B1**

(12) **EUROPÄISCHE PATENTSCHRIFT**

(45) Veröffentlichungstag der Patentschrift:
10.04.85

(51) Int. Cl.⁴: **H 01 L 29/74,** H 01 L 31/10,
H 01 L 29/52, H 01 L 29/08

(21) Anmeldenummer: **80106778.6**

(22) Anmeldetag: **04.11.80**

(54) Lichtzündbarer Thyristor und Verfahren zu seinem Betrieb.

(30) Priorität: **09.11.79 DE 2945335**

(43) Veröffentlichungstag der Anmeldung:
**27.05.81 Patentblatt 81/21**

(45) Bekanntmachung des Hinweises auf die Patenterteilung:
**10.04.85 Patentblatt 85/15**

(84) Benannte Vertragsstaaten:
**CH FR GB IT LI SE**

(56) Entgegenhaltungen:
**EP - A - 0 021 086
DE - A - 2 625 917
FR - A - 1 362 724**

**ELECTRONIQUE ET APPLICATIONS INDUSTRIELLES,
Nr. 281, März 1980, Paris, FR, Y. SOUSSI: "La
commande optique des courants alternatifs de
puissance", Seiten 30,31**

(73) Patentinhaber: **Siemens Aktiengesellschaft, Berlin und
München Wittelsbacherplatz 2, D-8000 München 2 (DE)**

(72) Erfinder: **Patalong, Hubert, Dr.,
Kurt-Floericke-Strasse 18, D-8000 München 60 (DE)**

## Beschreibung

Die Erfindung bezieht sich auf einen lichtzündbaren Thyristor nach dem Oberbegriff des Patentanspruchs 1 und auf Verfahren zu seinem Betrieb.

Lichtzündbare Thyristoren werden beispielsweise in dem Buch von E. Spenke «pn-Übergänge» (Band 5 der Reihe «Halbleiterelektronik») Springer-Verlag Berlin 1979, auf Seite 119 erwähnt. Sie müssen mit ihrer Zündempfindlichkeit an gesteuerte Lichtquellen, die nur eine geringe Lichtleistung haben, angepasst werden. Steigert man die Zündempfindlichkeit durch die Wegnahme von festen Emitter-Kurzschlüssen, so verringert sich gleichzeitig die Stabilität des Thyristors, d. h. seine Unempfindlichkeit gegenüber unerwünschten Zündvorgängen.

Aus der DE-A-26 25 917 ist ein lichtzündbarer Thyristor gemäss dem ersten Teil des Patentanspruchs 1 bekannt, bei dem jede gategesteuerte MIS-Struktur neben einem Randbereich einer Emitterschicht, die als Source- oder Draingebiet wirkt, ein in die angrenzende Basisschicht eingefügtes, sich bis zu der Halbleiteroberfläche erstreckendes, den selben Leitfähigkeitstyp wie die Emitterschicht aufweisendes und im Abstand zu dem genannten Randbereich angeordnetes Halbleitergebiet aufweist, das als Drain- oder Sourcegebiet wirkt. Der zwischen dem Drain- und Sourcegebiet liegende Kanal, der von einem gegen die Halbleiteroberfläche isolierten Gate überdeckt ist, verläuft hierbei in der Basisschicht. Ausserdem wird der pn-Übergang zwischen dem genannten Halbleitergebiet und der Basisschicht durch eine auf der Halbleiteroberfläche angebrachte Hilfselektrode leitend überbrückt. Die Lichteinstrahlung erfolgt schliesslich in die Basisschicht des Thyristors. Zum Unterschied hiervon sind bei der Erfindung weder ein im Abstand zum Randbereich der Emitterschicht angeordnetes Halbleitergebiet, noch ein in der Basisschicht verlaufender Kanal oder eine Hilfselektrode der genannten Art vorgesehen, da der erforderliche Thyristorquerschnitt durch diese Strukturmerkmale vergrössert wird.

Der FR-A-13 62 724, vergl. Fig. 9, ist ein elektrisch zündbarer Thyristor mit gategesteuerten MIS-Strukturen entnehmbar, bei dem ebenfalls ein Randbereich der Emitterschicht als Source- oder Draingebiet einer MIS-Struktur wirkt, während das zugehörige Drain- oder Sourcegebiet aus einem im Abstand vom Randbereich der Emitterschicht angeordneten, den selben Leitfähigkeitstyp wie die Emitterschicht aufweisenden, in die angrenzende Basisschicht eingefügten Halbleitergebiet gebildet wird, wobei der pn-Übergang zwischen diesem Halbleitergebiet und der Basisschicht durch eine Hilfselektrode leitend überbrückt wird. Auch hier verläuft der gategesteuerte Kanal in der Basisschicht.

Ferner wurde in der älteren europäischen Patentanmeldung EP-A-00 21 086 ein lichtsteuerbarer Thyristor vorgeschlagen, in dessen Halbleiterkörper ein Feldeffekttransistor und ein Fototransistor integriert sind. Dabei weisen die beiden Basisschichten des Thyristors Zonen auf, die sich bis zu der die kathodenseitige Hauptelektrode tragenden Oberfläche des Halbleiterkörpers erstrecken. In die p-Basisschicht ist ein inselförmiges n-leitendes Halbleitergebiet, das das Sourcegebiet des Feldeffekttransistors darstellt, im Abstand zu dem pn-Übergang zwischen beiden Basisschichten derart eingefügt, dass es sich bis zur genannten Oberfläche des Halbleiterkörpers erstreckt. Der an den pn-Übergang angrenzende Teil der n-Basisschicht bildet das Draingebiet, während sich das Kanalgebiet in dem durch eine Gateelektrode überdeckten Teil der p-Basisschicht befindet, der zwischen dem n-leitenden Halbleitergebiet und dem pn-Übergang liegt. Der Feldeffekttransistor wird beim Auftreten eines durch eine Beleuchtung des Fototransistors hervorgerufenen Fotostroms mit einer Gatespannung beaufschlagt, die den genannten Kanal entstehen lässt, so dass der pn-Übergang zwischen den beiden Basisschichten leitend überbrückt wird und der Thyristor zündet. Der Inhalt dieser Anmeldung gilt gemäss Artikel 54 (3) EPÜ als Stand der Technik.

Der Erfindung liegt die Aufgabe zugrunde, einen lichtzündbaren Thyristor anzugeben, der an Lichtquellen mit kleiner Lichtleistung angepasst ist und doch eine gute Stabilität aufweist. Diese Aufgabe wird erfindungsgemäss durch die im Patentanspruch 1 gekennzeichneten Merkmale gelöst.

Der mit der Erfindung erzielbare Vorteil besteht insbesondere darin, dass die den Bedarf an Querschnittsfläche des Thyristors nur geringfügig erhöhenden, steuerbaren Emitter-Kurzschlusspfade nur während des Zündvorgangs unwirksam geschaltet sind, wodurch die Zündfreudigkeit des Thyristors stark erhöht wird. Im blockierten Zustand des Thyristors sind sie ständig eingeschaltet, so dass ein gutes Stabilitätsverhalten erreicht wird.

Die Unteransprüche sind auf bevorzugte Weiterbildungen und Ausgestaltungen der Erfindung gerichtet, sowie auf Verfahren zum Betrieb eines erfindungsgemäss ausgebildeten Thyristors.

Die Erfindung wird nachfolgend anhand der Zeichnung näher erläutert, dabei zeigt:

Fig. 1 einen Querschnitt durch ein erstes Ausführungsbeispiel und

Fig. 2 einen Querschnitt durch ein zweites Ausführungsbeispiel.

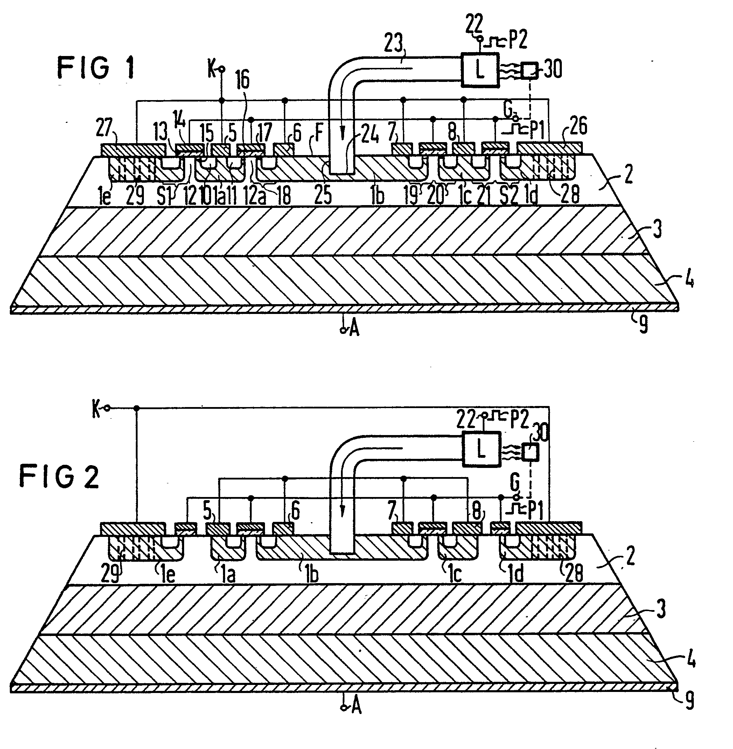

Der in Fig. 1 dargestellte Thyristor weist einen Halbleiterkörper mit Halbleiterschichten 1 bis 4 unterschiedlicher Leitfähigkeitstypen auf, die beispielsweise aus dotiertem Silizium bestehen. Dabei werden die aussenliegende N-leitende Schicht 1, die in drei Teilschichten 1a bis 1c aufgeteilt ist, als N-Emitterschicht und die aussenliegende P-leitende Schicht 4 als P-Emitterschicht bezeichnet. Die P-leitende Schicht 2 und die N-leitende Schicht 3 stellen die sogenannten Basisschichten dar. Die Teilschichten 1a bis 1c sind mit Teilen 5 bis 8 einer ersten Elektrode versehen, die miteinander leitend verbunden sind. In Fig. 1 sind diese Teile weiterhin mit einem Kathodenanschluss K verbunden, so dass es sich bei der ersten Elektrode um eine Kathode handelt. Die Teilschichten 1a bis 1c können streifenförmig ausgebildet sein und senkrecht zur Bildebene der Fig. 1 verlaufen. In diesem Fall sind auch die Teile 5 bis 8 der Kathode streifenförmig ausgebildet und verlaufen in gleicher Richtung. Die P-Emitterschicht 4 ist mit einer zweiten Elektrode 9 versehen, die mit einem Anodenanschluss A verbunden ist und daher eine Anode darstellt.

In die Teilschicht 1a sind P-leitende Halbleitergebiete 10, 11 so eingefügt, dass sie sich bis zur Grenzfläche des Halbleiterkörpers erstrecken. Dabei werden sie jeweils randseitig von dem Teil 5 der Kathode kontaktiert. Mit 12 und 12a sind Zonen der Basisschicht 2 bezeichnet, die bis zur Grenzfläche F reichen. Das Gebiet 10 bildet dabei ein erstes P-Gebiet, die Zone 12 ein zweites P-Gebiet und der dazwischenliegende Teil der Teilschicht 1a eine N-Zwischenschicht. Auf der Grenzfläche F ist eine dünne, elektrisch isolierende Schicht 13, z. B. aus SiO$_2$, vorgesehen, auf der ein Gate 14 so angeordnet ist, dass es die N-Zwischenschicht überdeckt. Die Teile 10, 1a, 12, 13 und 14 bilden eine MIS-Struktur. Gehört sie dem Verarmungstyp an, so befindet sich ohne Einwirkung einer Spannung auf das Gate 14 ein P-leitender Inversionskanal 15 an der Grenzfläche F zwischen den Gebieten 12, der diese miteinander leitend verbindet. Legt man eine positive Steuerspannung an einen Steuerspannungsanschluss G des Gate 14, so wird der Inversionskanal 15 beseitigt. Ist die MIS-Struktur vom Anreicherungstyp, so besteht bei spannungslosem Gate 14 kein Inversionskanal 15. Dieser wird erst durch das Anlegen einer negativen Steuerspannung an G durch Inversion der Teilschicht 1a unterhalb des Gate 14 aufgebaut.

Der Inversionskanal 15 stellt also zusammen mit den Gebieten 10 und 12 einen steuerbaren Emitter-Kurzschlusspfad dar, der die Basisschicht 2 mit dem Gebiet 10 und damit mit dem Teil 5 der Kathode in Abhängigkeit von einer dem Anschluss G zugeführten Steuerspannung wahlweise niederohmig verbindet.

Durch die Anordnung einer elektrisch isolierenden Schicht 16, z. B. aus SiO$_2$, auf der ein ebenfalls mit G verbundenes Gate 17 vorgesehen ist, ergibt sich in analoger Weise eine MIS-Struktur 11, 1a, 12a, 16 und 17, in der in Abhängigkeit von der bei G anliegenden Steuerspannung ein Emitter-Kurzschlusspfad zwischen der Basisschicht 2 und dem Teil 5 der Kathode wirksam geschaltet wird oder nicht. Andere Emitter-Kurzschlusspfade ergeben sich jeweils zwischen der Basisschicht 2 und den Teilen 6, 7 und 8. Diese sind durch die Bezugszeichen 18, 19, 20 und 21 gekennzeichnet. Alle beschriebenen Emitter-Kurzschlusspfade werden zweckmässigerweise über den mit ihren Gateanschlüssen verbundenen Anschluss G gesteuert.

Bei MIS-Strukturen des Verarmungstyps sind die Emitter-Kurzschlusspfade bei spannungslosem Anschluss G jeweils wirksam. Dabei befindet sich der Thyristor im blockierten Zustand, im dem trotz einer in Durchlassrichtung gepolten Spannung an den Anschlüssen A und K zwischen den letzteren praktisch kein Strom fliesst. Die thermisch generierten Defektelektronen werden aus der Basisschicht 2 zu den Teilen 5 bis 8 der Kathode abgeleitet, so dass aus den N-Emitterteilschichten 1a bis 1c keine Ladungsträger in die Basisschicht 2 injiziert werden. Es besteht also ein Zustand geringer Zündempfindlichkeit, bzw. hoher Stabilität.

Führt man dem Anschluss G einen positiven Spannungsimpuls P1 zu, so werden die Emitter-Kurzschlusspfade lediglich für die Dauer von P1 unwirksam geschaltet. Zusätzlich wird eine steuerbare Lichtquelle L, insbesondere eine Lumineszenzdiode, eine Laserdiode oder dergleichen, über einen Anschluss 22 mit einem Steuerimpuls P2 beaufschlagt, der eine Bestrahlung eines Teils des Halbleiter-Körpers durch einen Lichtleiter 23, z. B. einen Glasfaser-Lichtleiter, bewirkt. Hierdurch werden unterhalb des Endes 24 des Lichtleiters 23 durch die Lichteinwirkung in der Basisschicht 2 Ladungsträger erzeugt, die zusammen mit den thermisch generierten Ladungsträgern die in der Nähe des lichtaktiven Halbleiterbereichs liegenden N-Emitterteilschichten 1a bis 1c zur Injektion von Ladungsträgern in die Basisschicht 2 veranlassen. Der Thyristor zündet bereits bei kleinen Lichtleistungen der Lichtquelle L. Danach fliesst ein Laststrom eines an A und K angeschlossenen Lastkreises über den niederohmig geschalteten Thyristor. Die Abschaltung desselben wird zweckmässigerweise durch eine Abschaltung des Laststroms im Lastkreis erreicht, oder, wenn es sich bei der an A und K anliegenden Spannung um eine Wechselspannung handelt, durch den nachfolgenden Nulldurchgang.

In einigen Anwendungsfällen kann es erwünscht sein, MIS-Strukturen des Anreicherungstyps zu verwenden. Hierbei liegt dann G ständig an einer negativen Vorspannung, die während der Zündung durch einen positiven Impuls P1 aufgehoben oder überkompensiert wird, so dass während des Zündvorgangs an G keine Spannung, oder im Falle der Überkompensation ein positiver Spannungsimpuls anliegt.

Die Ladungsträgererzeugung im lichtaktiven Halbleiterbereich wird intensiviert, wenn man in der N-Emitterteilschicht 1b eine Vertiefung 25 vorsieht, von der das Ende 24 des Lichtleiters 23 aufgenommen wird.

Anstelle der N-Emitterschicht kann auch die P-Emitterschicht 4 in eine Mehrzahl von Emitter-Teilschichten aufgeteilt werden, die mit einzelnen, untereinander verbundenen Teilen der Anode belegt sind. Hierbei sind steuerbare P-Emitter-Kurzschlusspfade vorgesehen. Die Fig. 1 kann zur Darstellung dieser Variante herangezogen werden, wenn die Bezeichnungen der Anschlüsse A und K miteinander vertauscht werden, sämtliche Halbleiterteile mit den entgegengesetzten Leitfähigkeitstypen versehen werden und die zugeführten Spannungen bzw. Spannungsimpulse jeweils umgepolt werden. Der Spannungsimpuls P1 hat dann ein negatives Vorzeichen. Handelt es sich um MIS-Strukturen des Anreicherungstyps, so ist G eine positive Vorspannung zuzuführen, die durch einen negativen Impuls P1 kurzzeitig beseitigt oder überkompensiert wird.

Nach einer Weiterbildung der Erfindung sind in Fig. 1 noch weitere N-Emitterteilschichten 1d und 1e vorgesehen, die von weiteren Teilen der ersten Elektrode, bzw. Kathode 26 und 27 kontaktiert werden. Auch an diesen Teilschichten können steuerbare Emitter-Kurzschlusspfade S1 und S2 vorgesehen sein. Die Teilschichten 1d und 1e werden von Zonen 28, 29 der Basisschicht 2 durchdrungen, die sich bis zur Grenzfläche F erstrecken, und in dieser ebenfalls von den Teilen 26 und 27 kontaktiert werden. Die Zonen 28 und 29 bilden feste Emitterkurzschlüsse. Der durch die Teilschichten 1d und 1e ergänzte Thyristor, der für grössere Lastströme geeignet ist, wird dabei im Bereich der Teilschichten 1d und 1e durch die festen Emitterkurzschlüsse stabilisiert.

Mit Vorteil wird der Impuls P1 am Ausgang eines optoelektronischen Wandlers 30, z.B. einer Fotodiode, abgegriffen, die mit der gesteuerten Lichtquelle L in Lichtkontakt steht. Hierdurch wird eine vollständige galvanische Trennung der Anschlüsse des Thyristors vom Anschluss 22 erreicht, über den in diesem Fall die Zündung bei einer in Durchlassrichtung gepolten Spannung zwischen A und K allein gesteuert wird.

Das in Fig. 2 dargestellte Ausführungsbeispiel unterscheidet sich von Fig. 1 dadurch, dass die Teile 5 bis 8 der ersten Elektrode zwar untereinander, aber nicht mehr mit dem Kathodenanschluss K verbunden sind. Weiterhin sind die Teile 5 und 8 der ersten Elektrode in Richtung auf die Teilschichten 1d und 1e so weit verlängert, dass sie die PN-Übergänge zwischen den Teilschichten 1a und 1c und den an diesen Stellen angrenzenden Teilen der Basisschicht 2 überbrücken. Dabei entfällt der steuerbare Emitter-Kurzschlusspfad 10, 1a, 12, 13 und 14 und der entsprechende Pfad 21. Die weiterhin mit der Kathode verbundenen Teilschichten 1d und 1e bilden nunmehr die N-Hauptemitterschicht, während die Teilschichten 1a bis 1c als Hilfsemitterschichten dienen. Dementsprechend stellen die Teile 26 und 27 der ersten Elektrode die Kathode dar, während die Teile 5 bis 8 der ersten Elektrode die Bedeutung einer Hilfsemitterelektrode haben. Der sich beim Zündvorgang zwischen den Schichten 4 und 1a bis 1c aufbauende Strom stellt einen Hilfsstrom dar, der über die Teile 5 und 8 in Richtung auf die Teilschichten 1d und 1e hingelenkt wird, so dass im Bereich der letzteren eine schnelle Zündung erfolgt. Der Thyristor nach Fig. 2 ist wegen der inneren Zündverstärkung für grosse Anstiegsgeschwindigkeiten des zwischen Anode und Kathode fliessenden Laststroms geeignet. Mit Hilfsemitter-Elektroden versehene Thyristoren sind auf den Seiten 123 und 124 des eingangs genannten Buches beschrieben.

**Patentansprüche**

1. Lichtzündbarer Thyristor mit einem Halbleiterkörper, er eine aussenliegende, mit einer ersten Hauptelektrode (5 bis 8) versehene N-Emitterschicht (1a bis 1c), eine aussenliegende, mit einer zweiten Hauptelektrode (9) versehene P-Emitterschicht (4) und zwei an diese jeweils angrenzende Basisschichten (2, 3) aufweist, bei dem an einer Emitterschicht (1a bis 1c) gategesteuerte MIS-Strukturen (10, 12, 13, 14) vorgesehen sind, die steuerbare Emitter-Kurzschlusspfade enthalten, welche sich von der angrenzenden Basisschicht (2) bis zu der mit dieser Emitterschicht (1a bis 1c) verbundenen Hauptelektrode (5 bis 8) erstrecken, dadurch gekennzeichnet, dass in eine der Emitterschichten (1a bis 1c) Inseln (10) des entgegengesetzten Leitfähigkeitstyps eingefügt sind, die jeweils den Drain- (bzw. Source-) Bereich einer MIS-Struktur bilden, wobei sie im Randbereich der Emitterschicht (1a) angeordnet sind und sowohl an die Halbleiteroberfläche (F) als auch an die mit der Emitterschicht (1a) verbundene Hauptelektrode (5) angrenzen, dass der lateral benachbarte Bereich (12) einer der Basisschichten (2), der ebenfalls an die Halbleiteroberfläche (F) angrenzt, unter Weglassung einer zusätzlichen Hilfselektrode den Source- (bzw. Drain-) Bereich einer solchen MIS-Struktur darstellt und zusammen mit einem in der Emitterschicht (1a) ausgebildeten, gategesteuerten Kanal (15) einen Kurzschlusspfad über eine in die Emitterschicht (1a) eingefügte Insel (10) zur angrenzenden Hauptelektrode (5) bildet und dass die Lichteinstrahlung zur Zündung des Thyristors mittels eines im zentralen Bereich der Emitterschicht (1a bis 1c) endenden Lichtleiters (23) erfolgt, der von den am Rande der Emitterschicht (1a bis 1c) befindlichen MIS-Strukturen wenigstens teilweise eingeschlossen wird.

2. Lichtzündbarer Thyristor nach Anspruch 1, dadurch gekennzeichnet, dass die N-Emitterschicht (P-Emitterschicht) in eine Mehrzahl von streifenförmigen Teilschichten (1a bis 1c) aufgeteilt ist, die mit untereinander elektrisch verbundenen Teilen (5 bis 8) der ersten (zweiten) Hauptelektrode versehen sind, und dass eine Mehrzahl von streifenförmig ausgebildeten MIS-Strukturen randseitig zu den streifenförmigen Teilschichten (1a bis 1c) angeordnet sind.

3. Lichtzündbarer Thyristor nach Anspruch 2, dadurch gekennzeichnet, dass wenigstens eine weitere, mit festen Emitterkurzschlüssen (28, 29) versehene N-Emitterschicht (1d, 1e) vorgesehen ist, die von weiteren Teilen (26, 27) der Hauptelektrode kontaktiert wird.

4. Lichtzündbarer Thyristor nach Anspruch 1, dadurch gekennzeichnet, dass die Emitterschicht (1a bis 1c), an der die gategesteuerten MIS-Strukturen vorgesehen sind, mit einer die Hauptelektrode ersetzenden Hilfsemitterelektrode versehen ist, und dass an der die letztere tragenden Halbleiteroberfläche eine Hauptelektrode vorgesehen ist, die eine mit festen Emitterkurzschlüssen (28, 29) versehene Hauptemitterschicht (1d, 1e) kontaktiert.

5. Lichtzündbarer Thyristor nach einem der Ansprüche 1 bis 4, dadurch gekennzeichnet, dass in der Emitterschicht, an der die gategesteuerten MIS-Strukturen vorgesehen sind, eine das Ende (24) des Lichtleiters aufnehmende Vertiefung (25) vorhanden ist.

6. Lichtzündbarer Thyristor nach Anspruch 1, dadurch gekennzeichnet, dass die gategesteuerten MIS-Strukturen einen gemeinsamen Steueranschluss (G) haben, der mit dem Ausgang eines optoelektronischen Wandlers (30) verbunden ist, der mit einer gesteuerten Lichtquelle (L) in optischem Kontakt steht.

7. Verfahren zum Betrieb eines lichtzündbaren Thyristors nach Anspruch 1, dadurch gekennzeichnet, dass den gategesteuerten MIS-Strukturen ein die Kurzschlusspfade kurzzeitig aufhebender Spannungsimpuls (P1) zugeführt wird.

## Claims

1. A light-controllable thyristor having a semiconductor body which has an externally arranged N-emitter layer (1a to 1c), which is provided with a first main electrode (5 to 8), an externally arranged P-emitter layer (4), which is provided with a second main electrode (9), and two base layers (2, 3) which respectively adjoin these emitter layers, wherein, on one emitter layer (1a to 1c), there are arranged gatecontrolled MIS-structures (10, 12, 13, 14) which contain controllable emitter short-circuit paths extending from the adjoining base layer (2) to the main electrode (5 to 8) which is connected to the emitter layer (1a to 1c), characterised in that islands (10) of the opposite conductivity type are inserted into one of the emitter layers (1a to 1c), which islands respectively form the drain (or source) zone of an MIS-structure, the islands being arranged in the edge region of the emitter layer (1a) and adjoining both the semiconductor surface (F) and also the main electrode (5) which is connected to the emitter layer (1a); that the lateral adjacent zone (12) of one of the base layers (2), which likewise adjoins the semiconductor surface (F) with the omission of an additional auxiliary electrode, forms the source (or drain) zone of such an MIS-structure and, together with a gate-controlled channel (15), which is constructed in the emitter layer (1a), forms a short-circuit path, by way of an island (10) which is inserted into the emitter layer (1a), to the adjoining main electrode (5); and that the incident light radiation for ignition of the thyristor is effected by means of a light waveguide (23) which terminates in the central zone of the emitter layer (1a to 1c) and which is at least partially surrounded by the MIS-structures which are present at the edge of the emitter layer (1a to 1c).

2. A light-controllable thyristor as claimed in Claim 1, characterised in that the N-emitter layer (P-emitter layer) is divided into a plurality of strip-shaped sub-layers (1a to 1c) which are provided with parts (5 to 8) of the first (second) main electrode which are electrically connected to one another; and that a plurality of strip-shaped MIS-structures are arranged at the edges of the strip-shaped sub-layers (1a to 1c).

3. A light-controllable thyristor as claimed in Claim 2, characterised in that at least one further N-emitter layer (1d, 1e) is provided, having permanent emitter short-circuits (28, 29) and contacted by further parts (26, 27) of the main electrode.

4. A light-controllable thyristor as claimed in Claim 1, modified in that the emitter layer (1a to 1c), on which the gate-controlled MIS-structures are arranged, is provided with an auxiliary emitter electrode which replaces the main electrode; and that a main electrode is arranged on the semiconductor surface which supports the auxiliary emitter electrode, which main electrode contacts a main emitter layer (1d, 1e) provided with permanent emitter short-circuits (28, 29).

5. A light-controllable thyristor as claimed in one of Claims 1 to 4, characterised in that a recess (25), which accommodates the end (24) of the light waveguide, is available in the emitter layer on which the gate-controlled MIS-structures are arranged.

6. A light-controllable thyristor as claimed in Claim 1, characterised in that the gate-controlled MIS-structures have a common control terminal (G) which is connected to the output of an optoelectronic transducer (30) which is in optical contact with a controlled light source (L).

7. A method of operating a light-controllable thyristor as claimed in Claim 1, characterised in that the gate-controlled MIS-structures are supplied with a voltage pulse (P1) which temporarily breaks the short-circuit paths.

## Revendications

1. Thyristor pouvant être amorcé par la lumière et comportant un corps semiconducteur, qui possède une couche d'émetteur de type N extérieure (1a à 1c) équipée d'une première électrode principale (5 à 8), une couche d'émetteur de type P extérieure (4) munie d'une seconde électrode principale (9) et deux couches (2, 3) jouxtant ces couches d'émetteur, et dans lequel il est prévu sur une couche d'émetteur (1a à 1c) des structures MIS (10, 12, 13, 14) commandées par la grille et qui contiennent des voies de court-circuit d'émetteur pouvant être commandées et qui s'étendent depuis la couche de base limitrophe (2) jusqu'à l'électrode principale (5 à 8) reliée à cette couche d'émetteur (1a á 1c), caractérisé par le fait que dans l'une des couches d'émetteur (1a à 1c) se trouvent insérés des îlots (10) possédant le type de conductivité opposé et qui forment respectivement la région de drain (ou de source) d'une structure MIS, lesdits îlots étant disposés dans la zone marginale de la couche d'émetteur (1a) et s'étendant jusqu'au niveau de la surface (F) du semiconducteur et jouxtant également l'électrode principale (5) reliée à la couche d'émetteur (1a), que la région latérale voisine (12) de l'une des couches de base (2), qui s'étend également jusqu'à la surface (F) du semiconducteur, représente, dans le cas où l'on néglige une électrode auxiliaire supplémentaire, la région de source (ou de drain) d'une telle structure MIS et forme, en association avec un canale (15) commandé par la grille et réalisé dans la couche d'émetteur (1a), une voie de court-circuit passant par un îlot (10) inséré dans la couche d'émetteur (1a) et s'étendant jusqu'à l'électrode principale limitrophe (5), et que la pénétration de la lumière pour l'amorçage du thyristor s'effectue au moyen d'un guide de lumière (23) se terminant dans la région centrale de la couche d'émetteur (1a à 1c) et qui est enserré au moins partiellement par les structures MIS situées sur le bord de la couche d'émetteur (1a à 1c).

2. Thyristor pouvant être amorcé par la lumière suivant la revendication 1, caractérisé par le fait que la couche d'émetteur de type N (1a couche d'émetteur de type P) est subdivisé en une multiplicité de couche partielles en forme de bandes (1a á 1c), qui sont équipées de parties (5 à 8), reliées électriquement entre elles, de la première (seconde) électrode principale, et qu'une multiplicité de structures MIS réalisées sous la forme de bandes sont disposées marginalement par rapport aux couches partielles en forme de bandes (1a à 1c).

3. Thyristor pouvant être amorcé par la lumière suivant la revendication 2, caractérisé par le fait qu'il est prévu au moins une autre couche d'émetteur de type N (1d, 1e) équipée de courts-circuits d'émetteur permanents (28, 29) et qui est contactée par d'autres parties (26, 27) de l'électrode principale.

4. Thyristor pouvant être amorcé par la lumière suivant la revendication 1, caractérisé par le fait que la couche d'émetteur (1a à 1c), sur laquelle les structures MIS commandées par la grille sont prévues, est équipée d'une électrode d'émetteur auxiliaire remplaçant l'électrode principale, et qu'il est prévu sur la surface du semiconducteur portant ladite électrode, une électrode principale qui contacte une couche d'émetteur principal (1d, 1e) munie le courts-circuits d'émetteur permanents (28, 29).

5. Thyristor pouvant être amorcé par la lumière suivant l'une des revendications 1 à 4, caractérisé par le fait qu'un renfoncement (25) logeant l'extrémité (24) des guides de lumière est présent dans la couche d'émetteur, dans laquelle les structures MIS commandées par la grille sont prévues.

6. Thyristor pouvant être amorcé par la lumière suivant la revendication 1, caractérisé par le fait que les structures MIS commandées par la grille possèdent une borne de commande commune (G) qui est reliée à la sortie d'un convertisseur optoélectronique (30), qui est en contact optique avec une source de lumière commandée (L).

7. Procédé pour exploiter un thyristor pouvant être amorcé par la lumière suivant la revendication 1 caractérisé par le fait qu'une impulsion de tension (P1) supprimant pendant un bref intervalle de temps les voies de court-circuit est envoyée aux structures MIS commandées par la grille.

FIG 1

FIG 2